# EUROPÄISCHE PATENTSCHRIFT

(11) **EP 3 915 347 B1**
(45) Veröffentlichungstag und Bekanntmachung des Hinweises auf die Patenterteilung: **27.11.2024**
(21) Anmeldenummer: 20701280.8
(22) Anmeldetag: 16.01.2020
(51) Int. Cl.: H05K 7/14

(54) **HALTERUNGSEINRICHTUNG, SCHALTSCHRANK UND AUSLESEEINRICHTUNG**
MOUNTING DEVICE, SWITCHGEAR CABINET AND READ-OUT DEVICE
DISPOSITIF DE MAINTIEN, ARMOIRE DE COMMANDE ET DISPOSITIF DE RELEVÉ

(30) Priorität: 25.01.2019 DE 202019100449 U
(43) Veröffentlichungstag der Anmeldung: 01.12.2021
(73) Patentinhaber: Wago Verwaltungsgesellschaft mbH, 32423 Minden (DE)
(72) Erfinder: KULAS, Sascha, 30916 Isernhagen (DE); HEMPEN, Ulrich, 32427 Minden (DE)
(74) Vertreter: Kröncke, Rolf
(86) Internationale Anmeldenummer: PCT/EP2020/051026
(87) Internationale Veröffentlichungsnummer: WO 2020/152023

(56) Entgegenhaltungen:
- EP-A1- 3 187 886
- WO-A1-2009/064769
- DE-B3- 102016 122 157
- DE-C1- 4 410 817
- FR-A1- 2 967 832
- US-A1- 2007 252 670

## Beschreibung

Die Erfindung betrifft eine Halterungseinrichtung zur Befestigung einer oder mehrerer Leiteranschlussklemmen an einem Gegenstand, wobei die Halterungseinrichtung einen oder mehrere Befestigungsplätze aufweist, wobei an einem jeweiligen Befestigungsplatz wenigstens ein Fixierelement zur mechanischen Fixierung einer oder mehrerer Leiteranschlussklemmen an diesem Befestigungsplatz angeordnet ist. Die Erfindung betrifft außerdem einen Schaltschrank mit wenigstens einer derartigen Halterungseinrichtung sowie eine Ausleseeinrichtung zum Auslesen von erfassten Messwerten.

Derartige Halterungseinrichtungen sind beispielsweise durch Befestigungsadapter der Serie 221 der Anmelderin bekannt. Durch einen solchen Befestigungsadapter kann beispielsweise eine Befestigung der Leiteranschlussklemmen an einer Tragschiene realisiert werden. Eine weitere bekannte Halterungseinrichtung ist beispielsweise eine Herdanschlussdose, die ein Gehäuse mit mehreren Befestigungsplätzen aufweist, an denen jeweils eine oder mehrere Leiteranschlussklemmen befestigt werden können.

Aus der DE 44 10 817 C1 ist eine Stromerfassungseinrichtung an einer Tragschiene einer elektrischen Installationseinrichtung bekannt.

Der Erfindung liegt die Aufgabe zugrunde, eine für den Anwender einfach nutzbare Möglichkeit zur Erfassung physikalischer Größen der an der Halterungseinrichtung befestigten Leiteranschlussklemmen anzugeben, wie z.B. Strom, Spannung, Temperatur.

Diese Aufgabe wird mit einer Halterungseinrichtung gemäß Anspruch 1 gelöst. Dies beinhaltet, dass die Halterungseinrichtung wenigstens eine Sensoreinrichtung aufweist, die wenigstens einen Sensor zur Erfassung einer physikalischen Größe wenigstens einer an einem Befestigungsplatz befestigten Leiteranschlussklemme aufweist. Dies ermöglicht es, je nach Ausführung des wenigstens einen Sensors praktisch beliebige physikalische Größen der Leiteranschlussklemmen zu erfassen. Die Sensoreinrichtung kann auch mehrere Sensoren aufweisen, z.B. Sensoren für die Erfassung unterschiedlicher physikalischer Größen wie Strom und Spannung. Hierbei kann jeweils ein Befestigungsplatz zur Aufnahme und Fixierung genau einer Leiteranschlussklemme eingerichtet sein. Es kann auch eine variable Zuordnung möglich sein, beispielsweise derart, dass an einem Befestigungsplatz mehrere Leiteranschlussklemmen angeordnet werden können, wobei auch Leiteranschlussklemmen in einen benachbarten Befestigungsplatz hinüberragen können und dort zusätzlich fixiert sein können. Es kann auch eine Leiteranschlussklemme mehrere Befestigungsplätze belegen oder zumindest in einen oder zwei benachbarte Befestigungsplätze hinüberragen und dort ebenfalls fixiert sein. Als Leiteranschlussklemme wird in diesem Zusammenhang eine Leiteranschlussklemme zum Anschluss eines einzigen elektrischen Leiters oder eine Mehrfach-Leiteranschlussklemme verstanden, an der mehrere elektrische Leiter befestigt werden können und die für jeden zu befestigenden elektrischen Leiter eine eigene Leitereinführungsöffnung aufweist.

Gemäß der Erfindung ist vorgesehen, dass die Sensoreinrichtung baulich, zumindest teilweise oder vollständig, in ein Gehäuse der Halterungseinrichtung integriert ist.

Auf diese Weise kann die Sensoreinrichtung zumindest weitgehend vor Beschädigungen geschützt werden und zudem unauffällig untergebracht werden. Das Gehäuse der Halterungseinrichtung muss kein geschlossenes Gehäuse sein, es kann auch beispielsweise an einer Seite oder an mehreren Seiten Öffnungen aufweisen. Gemäß einer vorteilhaften Ausgestaltung der Erfindung ist vorgesehen, dass der wenigstens eine Sensor an einer Position in der Halterungseinrichtung angeordnet ist, in deren unmittelbarer Nähe eine Stromschiene einer an einem Befestigungsplatz befestigten Leiteranschlussklemme angeordnet ist. Dies erlaubt eine zuverlässige Sensierung der physikalischen Größe durch den wenigstens einen Sensor.

Gemäß einer vorteilhaften Ausgestaltung der Erfindung ist vorgesehen, dass einer, mehrere oder alle Befestigungsplätze der Halterungseinrichtung zur Befestigung einer Leiteranschlussklemme in Federkraftklemmtechnik eingerichtet sind. Die Ausführung der Leiteranschlussklemme in Federkraftklemmtechnik erlaubt eine einfache und zuverlässige Fixierung des elektrischen Leiters an dieser Leiteranschlussklemme. Die Leiteranschlussklemme kann hierzu einen Kontakteinsatz aufweisen, der wenigstens eine Klemmfeder zum Festklemmen des elektrischen Leiters aufweist, wobei der elektrische Leiter durch die Klemmfeder beispielsweise gegen eine Stromschiene geklemmt werden kann.

Gemäß einer vorteilhaften Ausgestaltung der Erfindung ist vorgesehen, dass die Halterungseinrichtung ohne die Sensoreinrichtung als passives Bauteil ohne eigene elektrische Funktionalität ausgebildet ist. Dies erlaubt eine einfache und kostengünstige Bereitstellung der Halterungseinrichtung. Die Halterungseinrichtung kann beispielsweise als einfaches Kunststoffbauteil, z.B. als Spritzguss-Bauteil, ausgebildet sein.

Gemäß einer vorteilhaften Ausgestaltung der Erfindung ist vorgesehen, dass wenigstens ein Fixierelement eines Befestigungsplatzes als Rast-Fixierelement ausgebildet ist, durch das eine Leiteranschlussklemme durch Verrastung am Befestigungsplatz befestigbar ist. Dies erlaubt eine einfache und bequeme Befestigung einer Leiteranschlussklemme an einem Befestigungsplatz. Zudem kann die Leiteranschlussklemme auch wieder von der Halterungseinrichtung gelöst werden.

Gemäß einer vorteilhaften Ausgestaltung der Erfindung ist vorgesehen, dass die Sensoreinrichtung eine Drahtlos-Übertragungseinheit aufweist, die zur drahtlosen Übertragung von Messwerten des wenigstens einen Sensors der Sensoreinrichtung an eine von der Sensoreinrichtung separate Ausleseeinrichtung eingerichtet ist. Dies hat den Vorteil, dass an der Halterungseinrichtung bzw. im Schaltschrank keine aufwendige Verkabelung für die Bereitstellung und Weiterleitung der Messwerte der Sensoreinrichtung angebracht werden muss. Stattdessen kann die Übertragung der Messwerte drahtlos erfolgen, z.B. durch Funk-Übertragung, induktive oder kapazitive Kopplung oder optische Datenübertragung. Es kann sich insbesondere um eine UHF-Drahtlosübertragung handeln, z.B. mit einer Übertragungsstrecke innerhalb des Schaltschranks. Die Sensoreinrichtung kann beispielsweise einen eigenen RFID-Transponder und/oder einen WLAN-Sender aufweisen, sodass die erfassten Messwerte, z.B. als vorverarbeitete Messwerte und/oder als Rohdaten, drahtlos über WLAN-Übertragung an eine Auswerteeinrichtung übertragen werden können. Die Drahtlos-Übertragungseinheit kann z.B. als Bluetooth-Modul ausgebildet sein. Die Drahtlos-Übertragungseinheit kann auch als einen vergleichbaren anderen Funkstandard oder einen sonstigen Drahtlos-Übertragungsstandard ausgebildet sein, z.b. als RFID-Transponder, als WLAN-Übertragungseinheit, als NFC-Übertragungseinheit oder als ZigBee-Übertragungseinheit.

Gemäß einer vorteilhaften Ausgestaltung der Erfindung ist vorgesehen, dass die Sensoreinrichtung eine erste Drahtlos-Übertragungseinheit zur Übertragung von Messwerten eines von der Sensoreinrichtung gemessenen Stroms und wenigstens eine zweite Drahtlos-Übertragungseinheit zur drahtlosen Übertragung von Messwerten einer von der Sensoreinrichtung gemessenen Spannung oder Potentials aufweist. Auf diese Weise können Strom und Spannung einer elektrischen Leitung erfasst werden. Dies ermöglicht es, beispielsweise in einer externen Ausleseeinrichtung oder einer Auswerteeinrichtung die elektrische Leistung zu bestimmen und dementsprechend eine Leistungsmessung in der Halterungseinrichtung durchzuführen. Die Sensoreinrichtung kann mit der ersten und der zweiten Drahtlos-Übertragungseinheit in Form einer Baueinheit oder in Form separater Baueinheiten ausgebildet sein, z. B. indem eine Baueinheit der Sensoreinrichtung die erste Drahtlos-Übertragungseinheit und die andere Baueinheit die zweite Drahtlos-Übertragungseinheit aufweist.

Die Versorgung der Sensoreinrichtung mit für den Betrieb der Sensoreinrichtung erforderlicher elektrischer Energie kann z.B. durch eine elektrische Leitung erfolgen.

Vorteilhaft ist es ebenfalls, die Sensoreinrichtung mit einer eigenen elektrischen Energiequelle auszurüsten, z.B. einem Akkumulator oder einer Batterie. Auf diese Weise ist eine autarke Funktionalität der Halterungseinrichtung mit der Sensoreinrichtung gewährleistet. In diesem Fall muss für die Energieversorgung keine elektrische Leitung zur Sensoreinrichtung verlegt werden.

Die Sensoreinrichtung kann ihre Energieversorgung auch direkt aus der durch den Sensor zu erfassenden physikalischen Größe, z. B. einem Strom und/oder einer Spannung ableiten. Im Falle einer berührungslosen Strommessung kann die elektrische Energie beispielsweise über das von dem zu messenden Strom erzeugte Magnetfeld abgeleitet werden.

Gemäß einer vorteilhaften Ausgestaltung der Erfindung ist vorgesehen, dass die Sensoreinrichtung zur drahtlosen Versorgung mit elektrischer Energie, die für den Betrieb der Sensoreinrichtung erforderlich ist, eingerichtet ist. Dies hat den Vorteil, dass die Sensoreinrichtung ohne eigene Energiequelle bereitgestellt werden kann. Zudem ist keine gesonderte Verkabelung für die Zuführung elektrischer Energie über elektrische Leitungen zur Sensoreinrichtung erforderlich. Auch dies vereinfacht die Installation der Sensoreinrichtung an der Halterungseinrichtung. Zudem wird die Wartung vereinfacht, da keine eigene Energiequelle der Sensoreinrichtung ausgetauscht oder aufgeladen werden muss. Die Übertragung der Energie kann z.B. durch Funk-Übertragung, induktive oder kapazitive Kopplung oder optische Übertragung erfolgen.

Wird eine optische Energieübertragung durchgeführt, kann das Sensormodul beispielsweise mit einer oder mehreren Solarzellen ausgebildet sein und daraus die für den Betrieb des Sensormoduls erforderliche elektrische Energie gewinnen. Im Falle induktiver oder kapazitiver Übertragung kann das Sensormodul beispielsweise induktiv oder kapazitiv von einer benachbarten Leiteranschlussklemme mit elektrischer Energie versorgt werden.

Gemäß einer vorteilhaften Ausgestaltung der Erfindung ist vorgesehen, dass die Sensoreinrichtung eine Energy-Harvesting-Einrichtung aufweist, die zur drahtlosen Aufnahme elektrischer Energie aus der Umgebung der Sensoreinrichtung und zur Bereitstellung der elektrischen Energie zur elektrischen Versorgung von Komponenten der Sensoreinrichtung eingerichtet ist. Auf diese Weise können praktisch beliebige Energiequellen in der Umgebung angezapft und für die elektrische Versorgung der Sensoreinrichtung genutzt werden.

Die Sensoreinrichtung kann außer den Messwerten des wenigstens einen Sensors auch zusätzliche Daten bereitstellen, z.B. eine Identifikationskennung, die zur Identifikation der Sensoreinrichtung genutzt werden kann. Auf diese Weise kann mit wenig Aufwand zwischen den Messwerten unterschiedlicher Sensoreinrichtungen unterschieden werden, insbesondere bei drahtloser Übertragung.

Die Sensoreinrichtung kann als Sensormodul ausgebildet sein, d.h. als Baueinheit, die sämtliche für den Betrieb der Sensoreinrichtung erforderlichen Bauteile aufweist. Das Sensormodul kann z.B. als MID (Molded Interconnect Devices) gefertigt werden. In diesem Fall können sämtliche Komponenten einschließlich der Elektronik des Sensormoduls in einem Kunststoffmaterial eingespritzt werden. Die Sensoreinrichtung kann auch separate Bauteile wie den wenigstens einen Sensor, eine Antenne und/oder eine Elektronikbaugruppe aufweisen. Diese separaten Bauteile können z.B. verteilt in der Halterungseinrichtung angeordnet sein und miteinander elektrisch verbunden sein. Die Sensoreinrichtung kann insbesondere eine Dipol-Antenne aufweisen.

Der wenigstens eine Sensor der Sensoreinrichtung kann beispielsweise ein Stromsensor zur Erfassung des elektrischen Stroms sein, z.B. des Stroms durch eine Stromschiene der Leiteranschlussklemme, ein Spannungssensor, ein Temperatursensor, ein Luftfeuchte-Sensor, ein Beschleunigungs-Sensor, ein Vibrationssensor oder ein sonstiger Sensor. Die Sensoreinrichtung kann auch mehrere gleichartige oder verschiedene Sensoren aufweisen. Weitere Sensoren können sein.

Gemäß einer Ausgestaltung der Erfindung ist vorgesehen, dass der wenigstens eine Sensor ein Stromsensor ist, wie z.B. ein Shunt. Der wenigstens eine Sensor kann auch ein kontaktloser Stromsensor sein. Beispielsweise kann der Stromsensor mittels eines AMR-Sensors, anderer magnetfeldabhängiger Widerstände (MDR - Magnetic Dependent Resistor) oder als Hall-Sensor ausgebildet sein. Dies erlaubt eine kontaktlose Erfassung des elektrischen Stroms über das durch den elektrischen Strom erzeugte Magnetfeld. Zudem wird hierdurch die nachträgliche Anbringung der Sensoreinrichtung an der Halterungseinrichtung vereinfacht. Ein weiterer Vorteil eines solchen Stromsensors besteht darin, dass gleichermaßen hohe Ströme, z.B. über 100 Ampere, ebenso wie niedrige Ströme von weniger als 1 Ampere gemessen werden können.

Gemäß einer vorteilhaften Ausgestaltung der Erfindung ist vorgesehen, dass der wenigstens eine Sensor ein Spannungssensor ist oder ein weiterer Sensor der Sensoreinrichtung ein Spannungssensor ist. Der Spannungssensor kann ein kontaktloser Spannungssensor sein, z.B. ein kapazitiver Sensor. Dies erlaubt eine kontaktlose Erfassung der elektrischen Spannung durch kapazitive Einkopplung in den Spannungssensor. Auch hierdurch wird die nachträgliche Anbringung der Sensoreinrichtung an der Halterungseinrichtung vereinfacht.

Gemäß einer vorteilhaften Ausgestaltung der Erfindung ist vorgesehen, dass die Sensoreinrichtung zur Erfassung von wenigstens zwei oder wenigstens drei Spannungspotentialen von an Befestigungsplätzen der Halterungseinrichtung befestigten Leiteranschlussklemmen eingerichtet ist. Sind Anschlussmöglichkeiten für die Erfassung von zwei Spannungspotenzialen gegeben, so kann damit beispielsweise das Spannungspotenzial des Nullleiters als Referenzspannungswert erfasst werden. Zusätzlich kann mit der anderen Anschlussmöglichkeit eine spannungsführende Leitung wie z. B. eine Phase eines Drehstromnetzes hinsichtlich des Spannungspotenzials erfasst werden. Auf diese Weise kann die Spannung beispielsweise an einer Phase gemessen werden. Sind weitere Anschlussmöglichkeiten für die Erfassung weiterer Spannungspotenziale vorhanden, so können auch die Spannungen von zwei oder allen drei Phasen eines Drehstromnetzes oder einer sonstigen elektrischen Versorgung erfasst werden.

Die Bestimmung der Spannung aus den erfassten Spannungspotenzialen kann in der Sensoreinrichtung, einer externen Ausleseeinrichtung oder einer gesonderten Auswerteeinrichtung erfolgen. Beispielsweise können die erfassten Spannungspotenzial-Messwerte drahtlos an die Ausleseeinrichtung übermittelt werden und so in der Ausleseeinrichtung der entsprechende Spannungswert und zusammen mit dem erfassten Stromwert der Leistungswert ermittelt werden.

Dementsprechend lässt sich auf einfache Weise und mit wenig Nachrüstungsaufwand eine Drei-Phasen-Leistungsmessung an einer Halterungseinrichtung realisieren.

Gemäß einer vorteilhaften Ausgestaltung der Erfindung ist vorgesehen, dass die Sensoreinrichtung zur Erfassung der Phasenlage eines von der Sensoreinrichtung erfassten Stroms gegenüber einem von der Sensoreinrichtung erfassten Spannungspotential eingerichtet ist. Auf diese Weise kann eine Phaseninformation der elektrischen Daten gewonnen werden und hierdurch die Überwachung der Halterungseinrichtung bzw. des Schaltschranks noch weiter verbessert werden. Je nach Schaltungsausführung der Sensoreinrichtung können auch weitere Informationen gewonnen werden, z. B. Informationen über die Spannung wie Frequenz, Phase, Betrag, Effektivwert und/ Oberwellen.

Gemäß einer vorteilhaften Ausgestaltung der Erfindung ist vorgesehen, dass die Halterungseinrichtung ein Tragschienenbefestigungselement aufweist, mit dem die Halterungseinrichtung zumindest teilweise formschlüssig an einer Tragschiene der elektrischen Installationstechnik befestigbar ist. Die Halterungseinrichtung kann über das Tragschienenbefestigungselement beispielsweise auf der Tragschiene aufgerastet werden.

Gemäß einer vorteilhaften Ausgestaltung der Erfindung ist vorgesehen, dass an der Halterungseinrichtung eine oder mehrere Leiteranschlussklemmen an jeweiligen Befestigungsplätzen befestigt sind.

Die eingangs genannte Aufgabe wird außerdem gelöst durch einen Schaltschrank mit wenigstens einer Halterungseinrichtung der zuvor erläuterten Art. Auch hierdurch werden die zuvor erläuterten Vorteile realisiert.

Gemäß einer Ausgestaltung der Erfindung ist vorgesehen, dass in dem Schaltschrank eine Ausleseeinrichtung zum Auslesen von erfassten Messwerten einer oder mehrerer Sensoreinrichtungen der Halterungseinrichtung angeordnet ist. Dies hat den Vorteil, dass nur eine kurze Übertragungsstrecke der erfassten Messwerte von der Sensoreinrichtung zur Ausleseeinrichtung zu überwinden ist. Dies ist insbesondere vorteilhaft für drahtlose Übertragungen, sowohl hinsichtlich der Messwerte als auch hinsichtlich der Versorgung mit elektrischer Energie. Beispielsweise kann die Ausleseeinrichtung ein Transponder-Lesegerät aufweisen. Auf diese Weise ist durch die Ausleseeinrichtung sowohl das Auslesen der Messwerte durch drahtlose Übertragung als auch die drahtlose Versorgung der Sensoreinrichtung mit elektrischer Energie möglich.

Die eingangs genannte Aufgabe wird außerdem gelöst durch eine Ausleseeinrichtung zum Auslesen von erfassten Messwerten einer oder mehrerer Sensoreinrichtungen der Halterungseinrichtung. Auch hierdurch werden die zuvor erläuterten Vorteile realisiert.

Die Ausleseeinrichtung kann auch bereits eine Auswerteeinrichtung zur Auswertung der erfassten Messwerte enthalten. Alternativ kann die Ausleseeinrichtung mit einer entfernt angeordneten Auswerteeinrichtung verbunden sein, z.B. über elektrische Leitungen oder über drahtlose Übertragung. Beispielsweise kann die Ausleseeinrichtung mit einem WLAN-Gerät verbunden sein oder ein solches aufweisen, über das die erfassten Messwerte drahtlos an die Auswerteeinrichtung übertragen werden.

Gemäß einer Ausgestaltung der Erfindung ist die Ausleseeinrichtung an der Innenseite einer Tür des Schaltschranks angeordnet. Dies hat den Vorteil, dass die Ausleseeinrichtung zumindest dann, wenn die Tür des Schaltschranks geschlossen ist, besonders nahe an einer oder mehreren Sensoreinrichtungen im Schaltschrank angeordnet ist, sodass für die drahtlose Übertragung nur eine besonders kurze Distanz zu überwinden ist.

Die Ausleseeinrichtung kann beispielsweise ein Bluetooth-Lesegerät und ein Gateway aufweisen. Die Ausleseeinrichtung liest drahtlos die Messwerte verschiedener Sensoreinrichtungen der Halterungseinrichtung aus. Die ausgelesenen Messwerte werden in ein entsprechendes Format umgewandelt und über verschiedene Schnittstellen, z.B. GSM, WLAN, weitergeleitet. Die Ausleseeinrichtung kann zudem als Messwandler und zur Normierung der Messwerte und Signale dienen. Die Ausleseeinrichtung kann z.B. eine Cloud-Anbindung über WLAN aufweisen. Die Ausleseeinrichtung fungiert damit als Multikommunikator (MUK).

Über das Gateway kann die Ausleseeinrichtung Messwerte und andere Daten an eine Auswerteeinrichtung übertragen oder Daten von einer Auswerteeinrichtung empfangen. Das Gateway kann z.B. eine Drahtlos-Schnittstelle für die Datenkommunikation aufweisen, z.B. GSM, WLAN.

Um die Messgenauigkeit der Sensoreinrichtung zu erhöhen, kann beispielsweise eine softwaremäßige Kalibrierung der erfassten Messwerte erfolgen, z.B. indem die Kalibrierung bereits in der Sensoreinrichtung anhand einer in der Sensoreinrichtung gespeicherten Kalibrierkurve durchgeführt wird, oder die Kalibrierung in der Ausleseeinrichtung anhand einer in der Ausleseeinrichtung gespeicherten Kalibrierkurve durchgeführt wird. Die Ausleseeinrichtung kann dann die zu einer Sensoreinrichtung passende Kalibrierkurve aus einer Vielzahl von Kalibrierkurven anhand der eindeutigen Identifikationskennung der Sensoreinrichtung auswählen. Eine in-situ-Kalibrierung mittels externem Strommessgerät ist auch möglich.

Gemäß einer Ausgestaltung der Erfindung ist vorgesehen, dass die Ausleseeinrichtung dazu eingerichtet ist, aus Strom- und Spannungsmesswerten, die die Ausleseeinrichtung von einer oder mehrerer Sensoreinrichtungen der Halterungseinrichtung ausgelesen hat, einen Leistungsmesswert zu bestimmen. Dies erlaubt eine noch genauere Überwachung der Halterungseinrichtung und damit des Schaltschranks.

Die Erfindung erlaubt damit eine Drei-Phasen-Leistungsmessung im Schaltschrank auf einfache Weise. Grundlage für die Umsetzung der Erfindung kann die UHF-RFID-Technik und Magnetfeldsensoren bieten. Die Hardware zur Drei-Phasen-Leistungsmessung kann aufgrund der realisierbaren Größe sehr einfach während des Herstellungsvorgangs in eine Halterungseinrichtung integriert werden oder relativ einfach nachträglich an der Halterungseinrichtung angebracht werden.

Im Sinne der vorliegenden Erfindung ist unter dem unbestimmten Begriff "ein" kein Zahlwort zu verstehen. Wenn also z.B. von einem Bauteil die Rede ist, so ist dies im Sinne von "mindestens einem Bauteil" zu interpretieren. Soweit Winkelangaben in Grad gemacht werden, beziehen sich diese auf ein Kreismaß von 360 Grad (360°). Soweit ein Rechner erwähnt ist, kann dieser dazu eingerichtet sein, ein Computerprogramm, z.B. im Sinne von Software, auszuführen. Der Rechner kann als handelsüblicher Computer ausgebildet sein, z.B. als PC, Laptop, Notebook, Tablet oder Smartphone, oder als Mikroprozessor, Mikrocontroller oder FPGA, oder als Kombination aus solchen Elementen. Soweit eine Regelung erwähnt ist, unterscheidet sich eine Regelung von einer Steuerung dadurch, dass eine Regelung eine Rückführung oder Rückkopplung gemessener oder interner Werte aufweist, mit der die erzeugten Ausgabewerte der Regelung wiederum im Sinne eines geschlossenen Regelkreises beeinflusst werden. Bei einer Steuerung erfolgt ein reines Steuern einer Größe ohne eine solche Rückführung oder Rückkopplung.

Die Erfindung wird nachfolgend anhand von Ausführungsbeispielen unter Verwendung von Zeichnungen näher erläutert.

Es zeigen
- Figur 1: eine Halterungseinrichtung in Draufsicht und
- Figur 2, 3: die Halterungseinrichtung gemäß Figur 1 in Seitenansicht und
- Figur 4: die Halterungseinrichtung gemäß Figur 1 in einer Ansicht von unten und
- Figur 5: eine weitere Ausführungsform einer Halterungseinrichtung in perspektivischer Darstellung und
- Figur 6: einen Schaltschrank in perspektivischer Darstellung und
- Figur 7: eine Leiteranschlussklemme in perspektivischer Darstellung und
- Figur 8: die Leiteranschlussklemme gemäß Figur 7 in seitlicher Schnittansicht.

Die in den Zeichnungen verwendeten Bezugszeichen haben folgende Zuordnung:
- 1: Leiteranschlussklemme
- 2: Isolierstoffgehäuse
- 3: Betätigungselement
- 4: Leitereinführungsöffnung
- 5: U-förmige Gehäusewandabschnitte
- 6: Freiraum
- 7a, 7b: Hebelarmabschnitte
- 8: Quersteg
- 9: Leitereinführungsöffnungs-Begrenzungswand
- 10: äußere Begrenzungswand
- 11: Federkraftklemmanschluss
- 12: Stromschiene
- 13: Klemmfeder
- 14: Anlageschenkel
- 15: Halteabschnitt
- 16: Ausnehmung
- 17: Haltesteg
- 18: Federbogen
- 19: Klemmschenkel
- 20: Klemmkante
- 22: teilkreisförmiger Lagerabschnitt
- 23: Schwenklagerbereich
- 24: Betätigungskontur
- 25: hinteres Deckelteil
- 26: vorderen Gehäuseteil
- 29: Frontbereich der Leitereinführungsöffnung
- 30: Halterungseinrichtung
- 31: Befestigungsplätze
- 32: rahmenartiges Gehäuse
- 33: rückwärtiges Fixierelement
- 34: vordere Fixierelemente
- 35: Rastnase/Rastelement
- 36: manuelles Betätigungselement
- 37: Tragschienenbefestigungselement
- 38: Wand
- 40: Sensoreinrichtung
- 41: Sensoren
- 42: Rechner
- 43: Drahtlos-Übertragungseinrichtung
- 44: Batterien/Energiequelle
- 45: Leiterplatte
- 50: elektrischer Installationsartikel
- 60: Tragschiene
- 100: Schaltschrank
- 101: Gehäusekorpus
- 102: Tür
- 200: Ausleseeinrichtung
- 201: Drahtlos-Datenübertragungsmodul
- 210: Kabel
- L: Leitereinsteckrichtung
- O: Oberseite
- U: Unterseite

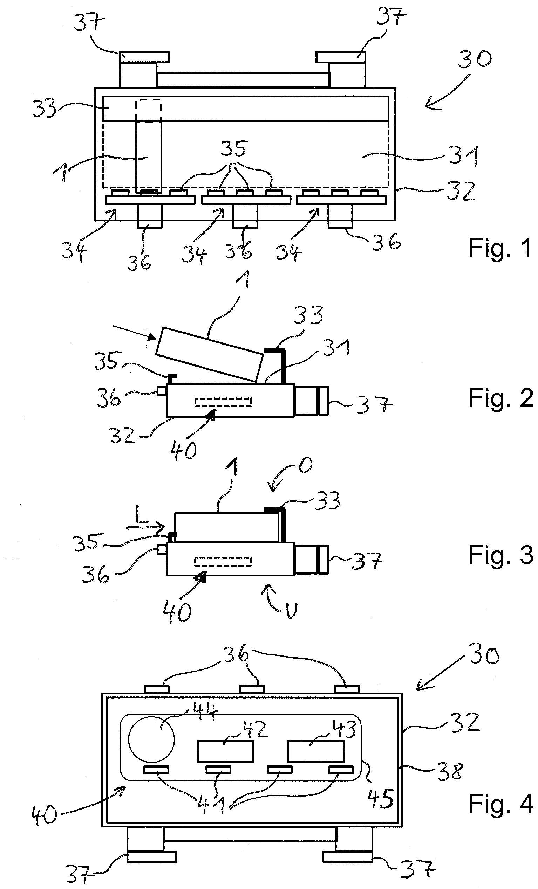

Die in Figur 1 dargestellte Halterungseinrichtung 30 weist ein rahmenartiges Gehäuse 32 auf, das an einer in der Draufsicht gemäß Figur 1 erkennbaren Oberseite einen Befestigungsbereich für Leiteranschlussklemmen 1 aufweist, der einen oder mehrere Befestigungsplätze 31 bildet. Zur mechanischen Fixierung von Leiteranschlussklemmen 1 an einem Befestigungsplatz 31 ist ein rückwärtiges Fixierelement 33 vorhanden, das einen rückwärtigen Bereich einer Leiteranschlussklemme 1 übergreift. Zur Fixierung der Leiteranschlussklemme 1 im vorderen Bereich, wo die Leiteranschlussklemme 1 eine Leitereinführungsöffnung zur Einführung eines elektrischen Leiters aufweist, weist die Halterungseinrichtung 30 mehrere vordere Fixierelemente 34 auf. Die vorderen Fixierelemente 34 weisen jeweils eine oder mehrere abragende Rastnasen 35 auf, in die eine Leiteranschlussklemme 1 mit einem kurzen vorderen Abschnitt ihrer Leitereinführungsöffnung eingerastet werden kann. Ferner weisen die vorderen Fixierelemente 34 jeweils wenigstens ein manuelles Betätigungselement 36 auf, über das bei entsprechender manueller Betätigung die Fixierung zwischen einem Rastelement 35 und einer Leiteranschlussklemme 1 aufgehoben werden kann.

In einem rückwärtigen, von den vorderen Fixierelementen 34 abgewandten Bereich weist die Halterungseinrichtung 30 eine oder mehrere Tragschienenbefestigungselemente 37 auf. Mit solchen Tragschienenbefestigungselementen 37 kann die Halterungseinrichtung zumindest teilweise formschlüssig an einer Tragschiene der elektrischen Installationstechnik befestigt werden, z.B. derart, dass die Halterungseinrichtung in vergleichbarer Weise auf die Tragschiene aufgerastet wird, wie bei einer Reihenklemme bekannt.

Die Figuren 2 und 3 zeigen in Seitenansicht die Befestigung einer Leiteranschlussklemme 1 an einem Befestigungsplatz 31 der Halterungseinrichtung 30. Die Leiteranschlussklemme 1 wird zunächst mit ihrer Rückseite, d.h. der von der Leitereinführungsöffnung abgewandten Seite, voran unterhalb des hakenartigen hinteren Fixierelementes 33 geschoben und dann durch eine Abwärtsbewegung mit ihrer Vorderseite unter einem Rastelement 35 eingerastet. Das Rastelement 35 schnappt dabei etwas in den vorderen Bereich der Leitereinführungsöffnung hinein und fixiert somit die Leiteranschlussklemme durch Halten des die Leitereinführungsöffnung umgebenden Isolierstoffmaterials des Isolierstoffgehäuses der Leiteranschlussklemme 1. Durch manuelle Betätigung des Betätigungselementes 36 von oben her, d.h. von der Oberseite O her, kann das Rastelement 35 etwas ausgelenkt und damit wieder aus der Leitereinführungsöffnung der Leiteranschlussklemme 1 herausbewegt werden. Auf diese Weise kann die Leiteranschlussklemme 1 wieder von der Halterungseinrichtung 30 entfernt werden.

Die Figuren 2 und 3 zeigen in gestrichelter Darstellung (weil nicht sichtbar) das Vorhandensein einer Sensoreinrichtung 40 innerhalb des vom Gehäuse 32 umgebenen Bereiches. Das Gehäuse 32 kann an einer Unterseite U geschlossen oder teilweise oder vollständig geöffnet ausgebildet sein. Die Figur 4 zeigt die Halterungseinrichtung 30 von der Unterseite U her, wobei von einer offenen Gehäuseunterseite ausgegangen wird.

In dieser Darstellung ist die Sensoreinrichtung 40 mit weiteren Details erkennbar. Die Sensoreinrichtung 40 weist ein oder mehrere Sensoren 41 auf, z.B. in Form von berührungslos agierenden Sensoren, z.B. Hall-Sensoren. Die Sensoreinrichtung 40 weist zur elektrischen Stromversorgung eine oder mehrere Batterien 44 auf, z.B. in Form von Knopfzellen. Die Sensoreinrichtung 40 weist ferner einen Rechner 42 sowie eine Drahtlos-Übertragungseinrichtung 43 auf. Durch den Rechner 42 kann ein Auswerteprogramm ausgeführt werden, mit dem die Werte der Sensoren 41 erfasst werden, gegebenenfalls bereits vorverarbeitet und/oder ausgewertet werden und entweder die unmittelbar erfassten Daten der Sensoren 41 und/oder solche ausgewerteten Daten über die Drahtlos-Übertragungseinheit 43 an eine entfernte Auswerteeinheit übertragen werden. Die beschriebenen Elemente der Sensoreinrichtung 40, d.h. die Sensoren 41, die Energiequelle 44, der Rechner 42 und/oder die Drahtlos-Übertragungseinheit 43 können auf einer Leiterplatte 45 angeordnet sein. Auf diese Weise kann mittels eines Sensors 41 oder mehrerer Sensoren 41 eine oder mehrere physikalische Größen einer an einem Befestigungsplatz 31 befestigten Leiteranschlussklemme 1 erfasst werden, z.B. der durch eine Stromschiene der Leiteranschlussklemme 1 fließende Strom sowie das dort vorhandene Spannungspotential.

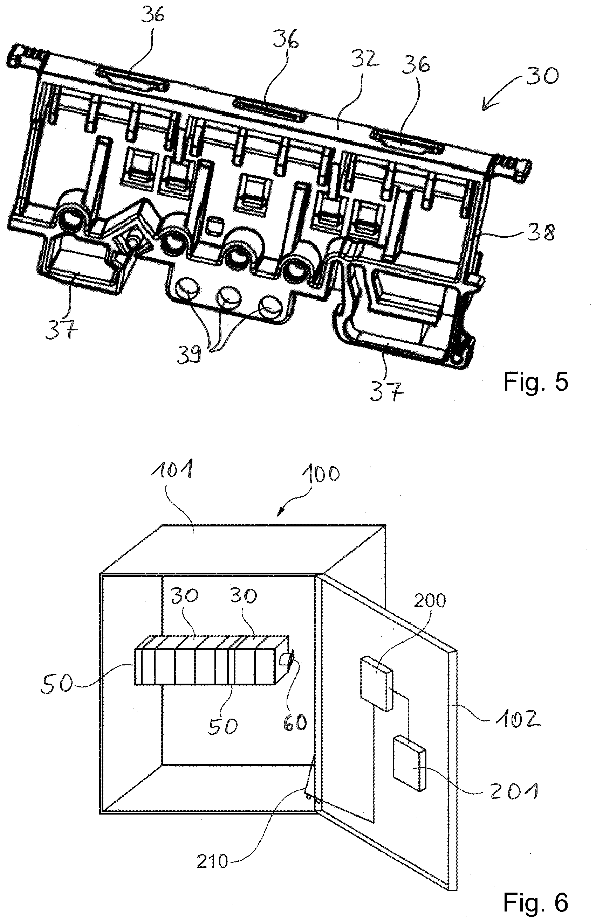

Die Figur 5 zeigt eine Halterungseinrichtung 30, die vergleichbar ausgebildet ist wie die bereits erläuterte Halterungseinrichtung 30, jedoch mit weiteren Details ausgestattet ist. Die Halterungseinrichtung 30 ist von der Unterseite U her dargestellt, wobei zur besseren Veranschaulichung die dort erfindungsgemäß anzuordnende Sensoreinrichtung 40 nicht mit dargestellt ist.

Erkennbar ist, dass zumindest eines der Tragschienenbefestigungselemente 37 als relativ flexibles, federndes Bauteil ausgebildet sein kann, sodass eine ausreichende Nachgiebigkeit für das Aufrasten der Halterungseinrichtung 30 auf der Tragschiene und ein eventuelles späteres Entfernen der Halterungseinrichtung 30 von der Tragschiene gewährleistet ist.

Erkennbar ist zudem, dass die Halterungseinrichtung 30 auch alternative Befestigungselemente, d.h. zusätzlich oder alternativ zu den Tragschienenbefestigungselementen 37, aufweisen kann. Beispielsweise kann die Halterungseinrichtung 30 mehrere Durchgangslöcher an verschiedenen Stellen aufweisen, über die die Halterungseinrichtung 30 an einem Gegenstand angeschraubt, angenietet oder angenagelt werden kann.

In der Figur 4 ist ferner erkennbar, dass der von der Unterseite U her erkennbare Einbauraum für die Sensoreinrichtung 40 von einer rahmenartigen, den Einbauraum umgebenden Wand 38 des Gehäuses 32 umrandet sein kann.

Diese Wand 38 muss dabei nicht in allen Ausführungsformen so regelmäßig gradlinig verlaufen, wie in Figur 4 dargestellt, sondern kann auch beispielsweise den weitaus kurvenreicheren Verlauf gemäß Figur 5 oder andere Gestaltungen annehmen.

Die Figur 5 zeigt einen Schaltschrank 100 in perspektivischer Darstellung. Der Schaltschrank 100 weist einen Gehäusekorpus 101 und eine Tür 102 auf. Die Tür 102 ist verschwenkbar mit dem Gehäusekorpus 101 verbunden. Die Figur 5 zeigt den Schaltschrank 100 bei geöffneter Tür 102. Im Gehäusekorpus 101 befindet sich an einer Rückwand eine Tragschiene 60. An der Tragschiene 60 sind mehrere Halterungseinrichtungen 30 befestigt, die jeweils mehrere Leiteranschlussklemmen 1 und eine Sensoreinrichtung 40 aufweisen. Es können dort weitere elektrische Installationsartikel 50 anordnet sein.

Die Figur 5 zeigt außerdem eine Ausleseeinrichtung 200, die zum drahtlosen Auslesen von Messwerten der Sensoreinrichtungen 40 eingerichtet ist. Die Ausleseeinrichtung 200 kann mit einem Drahtlos-Datenübertragungsmodul 201 verbunden sein oder dieses enthalten, z.B. eine WLAN-Einheit. Auf diese Weise können die von der Ausleseeinrichtung 200 ermittelten Messwerte der Sensoreinrichtungen 40 drahtlos an eine entfernte Auswerteeinrichtung übertragen werden. Alternativ kann die Ausleseeinrichtung 200 auch über ein Kabel 210 mit der Auswerteeinrichtung verbunden sein, z.B. über ein Datennetzwerk.

Die Ausleseeinrichtung 200 und/oder die Drahtlos-Datenübertragungseinheit 201 kann in der Tür 102 angeordnet sein, d.h. an der Innenseite der Tür 102. Wird die Tür 102 geschlossen, befindet sich die Ausleseeinrichtung 200 in unmittelbarer Nähe der Antennen der Sensoreinrichtungen 40.

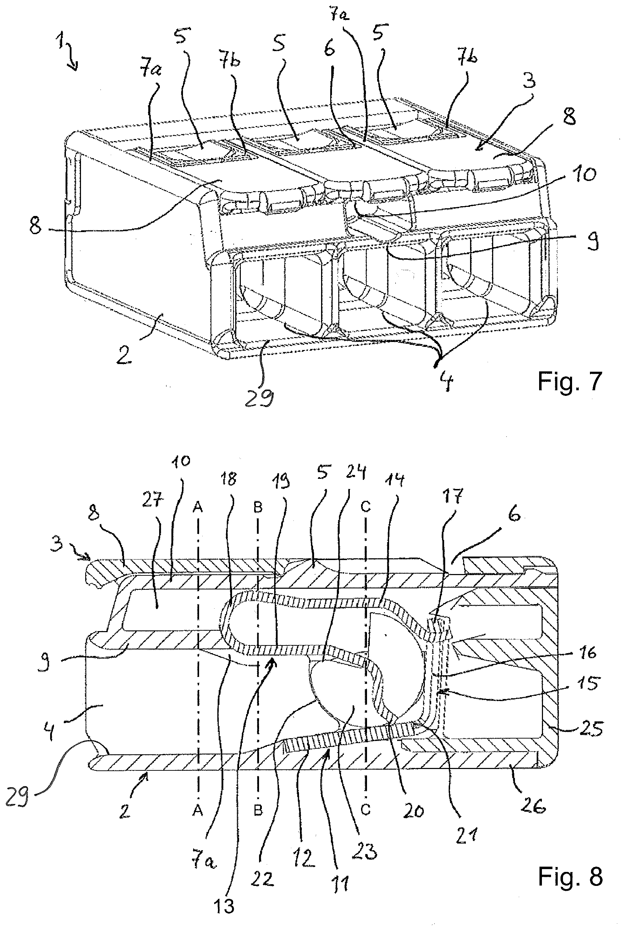

Die Leiteranschlussklemme 1 kann als Einzelleiter-Leiteranschlussklemme ausgebildet sein, wie in den Figuren 1 bis 3 angedeutet ist. Die Leiteranschlussklemme 1 kann auch als Mehrleiter-Anschlussklemme ausgebildet sein, die für den Anschluss mehrerer elektrischer Leiter ausgebildet ist. Die Figuren 7 und 8 zeigen beispielhaft eine Ausführungsform einer Leiteranschlussklemme 1, die für den Anschluss dreier elektrischer Leiter ausgebildet ist und daher drei Leitereinführungsöffnungen 4 aufweist.

Figur 7 lässt eine perspektivische Ansicht einer Leiteranschlussklemme 1 in Form einer hebelbetätigten Dosenklemme mit einem Isolierstoffgehäuse 2 und nebeneinander angeordneten Betätigungselementen 3 erkennen. In das Isolierstoffgehäuse 2 sind frontseitig nebeneinander angeordnete Leitereinführungsöffnungen 4 vorgesehen, über die jeweils zugeordnete Federkraftklemmanschlüsse (nicht sichtbar) für einen eine Leitereinführungsöffnung eingesteckten elektrischen Leiter zum Anklemmen desselben zugänglich sind. Durch Verschwenken des Betätigungselementes 3 vom dargestellten heruntergeschwenkten, geschlossenen Zustand in einen (nicht dargestellten) heraufgeschwenkten, geöffneten Zustand wird durch das Betätigungselement 3 eine Klemmfeder eines Federkraftklemmanschlusses beaufschlagt und eine durch die Klemmfeder und eine Stromschiene des Federkraftklemmanschlusses gebildete Klemmstelle zum Anschließen oder Entnehmen eines angeklemmten elektrischen Leiters geöffnet.

Weiterhin ist erkennbar, dass an der Oberseite der Leiteranschlussklemme 1 im Querschnitt U-förmige Gehäusewandabschnitte 5 einer äußeren Begrenzungswand des Isolierstoffgehäuses 2 jeweils in einen Freiraum 6 eines zugeordneten U-förmigen Betätigungselementes 3 hineinragen, wenn das Betätigungselement 3 heruntergeschwenkt ist. In dem heruntergeschwenkten, geschlossenen Zustand des zugeordneten Betätigungselementes 3 füllen diese U-förmigen Gehäusewandabschnitte 5 den Freiraum 6 mindestens teilweise aus. Die U-förmigen Gehäusewandabschnitte 5 schließen bevorzugt auf der Oberseite bündig mit der durch die oberen Randkanten des Isolierstoffgehäuses 2 gebildeten oberen Ebene des Isolierstoffgehäuses 1 ab.

Unter "oberer" bzw. "oben" wird die Seite der Leiteranschlussklemme 1 verstanden, an der die Betätigungselemente 3 in Form von schwenkbaren Betätigungshebeln angeordnet sind.

Deutlich wird, dass die Betätigungselemente 3 zwei voneinander beabstandete Hebelarmabschnitte 7a, 7b und einen die beiden Hebelarmabschnitte 7a, 7b miteinander verbindenden Quersteg 8 aufweisen. Damit wird ein im Querschnitt U-förmiger Schwenkhebel geschaffen, dessen Hebelarmabschnitte 7a, 7b teilweise in das Isolierstoffgehäuse 2 hineinragen und einen nicht sichtbaren Schwenklagerbereich bilden. Über den Schwenklagerbereich wird nicht nur die Drehachse für den Schwenkhebel, d.h. für das Betätigungselement 3, sondern auch eine mit einem Hebelarmabschnitt verbundene Betätigungskontur zur Beaufschlagung einer Klemmfeder des Federkraftklemmanschlusses zum Öffnen einer durch die Klemmfeder gebildeten Klemmstelle bereitgestellt.

Durch die Ausführungsform des Betätigungselementes 3 mit zwei voneinander beabstandeten Hebelarmabschnitten 7a, 7b, die in das Isolierstoffgehäuse 2 eintauchen und dort schwenkbar gelagert sind, und den die zwei Hebelarmabschnitte 7a, 7b miteinander verbindenden Quersteg 8 wird ein sehr knickstabiler Schwenkhebel geschaffen, der äußerst kompakt und flach bauend ist. Der Quersteg 8 bietet dabei eine breite Grifffläche, um mit der Hand oder einem Betätigungswerkzeug eine Betätigungskraft zum Verschwenken des Betätigungselementes 3 auf den Schwenkhebel aufzubringen.

Erkennbar ist weiterhin, dass für den mittleren Federkraftklemmanschluss ein als Prüföffnung beidseits geöffneter Zwischenraum zwischen einer Leitereinführungsöffnungs-Begrenzungswand 9 und einer äußeren Begrenzungswand 10 des Isolierstoffgehäuses 2 gebildet ist, über den der zugeordnete Federkraftklemmanschluss (nicht sichtbar) für ein Prüfwerkzeug zugänglich ist. Grundsätzlich ist auch eine Prüföffnung von der Rückseite möglich.

Figur 8 lässt eine Seiten-Schnittansicht durch die Leiteranschlussklemme 1 aus Fig. 7 im Bereich eines geöffneten Betätigungselementes 3 erkennen. Dabei ist auch der Federkraftklemmanschluss 11 sichtbar, der eine quer zur Leitereinsteckrichtung L sich erstreckende Stromschiene 12 und eine Klemmfeder 13 aufweist. Die Klemmfeder 13 ist mit einem Anlageschenkel 14 in die Stromschiene 12 eingehängt.

Hierzu hat die Stromschiene 12 einen in Richtung Betätigungselement 3 nach oben abgewinkelten Halteabschnitt 15 mit einer Ausnehmung 16, die das Hindurchstecken eines elektrischen Leiters ermöglicht. Diese Ausnehmung 16 ist am freien Ende durch einen Haltesteg 17 begrenzt, an dem der Anlageschenkel 14 der Klemmfeder 13 anliegt. Die Klemmfeder 13 ist somit über den Haltesteg 17 an der Stromschiene 12 festgelegt. An den Anlageschenkel 14 schließt sich ein Federbogen 18 an, von dem sich der Klemmschenkel 19 mit einer Klemmkante 20 am freien Ende erstreckt. Deutlich wird, dass der Klemmschenkel 19 in seinem Endabschnitt mit einem Winkel von etwa 70° bis 110°, bevorzugt etwa 85° bis 95°, abgebogen ist. Von diesem abgebogenen Abschnitt ist dann das freie Ende mit der Klemmkante 20 wieder in Leitereinführungsrichtung zurückgebogen. Auf diese Weise steht der hier um etwa 90° abgebogene Abschnitt quer zur Leitereinsteckrichtung, so dass ein direktes Einstecken eines mehrdrähtigen bzw. feindrähtig elektrischen Leiters ohne vorheriges Öffnen der Klemmstelle durch Herumschwenken des Betätigungselementes 3 verhindert wird.

Der Klemmschenkel 19 bildet dann durch Umbiegung einen Raum zur Aufnahme des freien abisolierten Endes des eingesteckten elektrischen Leiters und geht oberhalb der Leitereinführungsöffnung 4 in einen Federbogen 18 über. An den Federbogen 18 schließt sich ein Klemmschenkel 19 an, wobei das freie Ende des Klemmschenkels 19 eine Klemmkante 20 aufweist. Zwischen der Klemmkante 20 und der Stromschiene 12 wird eine Klemmstelle zum Anklemmen eines elektrischen Leiters (nicht dargestellt) gebildet.

Deutlich wird weiterhin, dass bei dieser Ausführungsform die Stromschiene 12 gegenüber der durch die Erstreckungsrichtung der Leitereinführungsöffnung 4 definierten Leitereinführungsrichtung L hin geneigt ist. Die Stromschiene 12 ist insbesondere relativ zur oberen Leitereinführungsöffnungs-Begrenzungswand 9 und des vorderen Abschnitts der gegenüberliegenden unteren Leitereinführungsöffnungs-Begrenzungswand um etwa 5° bis 25° geneigt. Damit wird eine Auflaufschräge für den elektrischen Leiter sowie an der Stromschiene 12 im Übergang zur Ausnehmung 16 eine Kontaktkante 21 bereitgestellt, die zusammen mit der Klemmkante 20 der Klemmfeder 13 eine definierte Klemmstelle bildet.

Deutlich wird weiterhin, dass der Hebelarmabschnitt 7a in den vom Isolierstoffgehäuse 2 umschlossenen Raum hineintaucht und in einem teilkreisförmigen Lagerabschnitt 22 des Isolierstoffgehäuses 2 schwenkbar mit einem Schwenklagerbereich 23 des Hebelarmabschnitts 7a gelagert ist. An diesem Schwenklagerbereich 23 ist eine Betätigungskontur 24 vorgesehen, die mit einem seitlich vorstehenden Betätigungslappen (nicht sichtbar) des Klemmschenkels 19 der Klemmfeder 13 zusammenwirkt. Beim Verschwenken des Betätigungselementes 3 in die Offenstellung wird durch die Rotationsbewegung der Betätigungskontur 24 der Betätigungslappen verlagert, um die Klemmkante 20 des Klemmschenkels 19 der Klemmfeder 13 von der Stromschiene 12 weg zu bewegen und hierdurch die Klemmstelle für einen elektrischen Leiter zu öffnen.

Deutlich wird, dass der stirnseitig teilkreisförmige Schwenklagerbereich 23 am teilkreisförmigen Lagerabschnitt 22 drehgelagert ist. Der Schwenklagerbereich 23 liegt dabei auch auf der Stromschiene 12 auf, die ebenfalls zur Lagerung des Betätigungselementes 3 beiträgt.

Erkennbar ist weiterhin, dass das Isolierstoffgehäuse 2 zweiteilig ausgebildet ist.

Hierbei ist ein hinteres Deckelteil 25 mit einem vorderen Gehäuseteil 26 durch Rastlaschen und/oder Rastöffnungen verrastet. Nach Einführen des Betätigungselementes 3 und des zugeordneten Federkraftklemmanschlusses 11 in das vordere Gehäuseteil 26 wird dieses durch Einschieben und Verrasten des rückseitigen Deckelteils 25 geschlossen.

Die Befestigung der Leiteranschlussklemme 1 an einer Halterungseinrichtung 30 mittels der vorderen Fixierelemente 34 und insbesondere der Rastelemente 35 erfolgt derart, dass ein jeweiliges Rastelement 35 den in den Figuren 7 und 8 dargestellten Frontbereich 29 der Leitereinführungsöffnung 4 hintergreift.

## Patentansprüche

1. Halterungseinrichtung (30) zur Befestigung einer oder mehrerer Leiteranschlussklemmen (1) an einem Gegenstand, wobei die Halterungseinrichtung (30) einen oder mehrere Befestigungsplätze (31) aufweist, wobei an einem jeweiligen Befestigungsplatz (31) wenigstens ein Fixierelement (33, 34) zur mechanischen Fixierung einer oder mehrerer Leiteranschlussklemmen (1) an diesem Befestigungsplatz (31) angeordnet ist, wobei die Halterungseinrichtung (30) wenigstens eine Sensoreinrichtung (40) aufweist, die wenigstens einen Sensor (41) zur Erfassung einer physikalischen Größe wenigstens einer an einem Befestigungsplatz (31) befestigten Leiteranschlussklemme (1) aufweist, **dadurch gekennzeichnet, dass** die Sensoreinrichtung (40) baulich in ein Gehäuse (32) der Halterungseinrichtung (30) integriert ist.

2. Halterungseinrichtung nach einem der vorhergehenden Ansprüche, **dadurch gekennzeichnet, dass** der wenigstens eine Sensor (41) an einer Position der Halterungseinrichtung (30) angeordnet ist, in deren unmittelbarer Nähe eine Stromschiene (11) einer an einem Befestigungsplatz (31) befestigten Leiteranschlussklemme (1) angeordnet ist.

3. Halterungseinrichtung nach einem der vorhergehenden Ansprüche, **dadurch gekennzeichnet, dass** einer, mehrere oder alle Befestigungsplätze (31) der Halterungseinrichtung (30) zur Befestigung einer Leiteranschlussklemme (1) in Federkraftklemmtechnik eingerichtet sind.

4. Halterungseinrichtung nach einem der vorhergehenden Ansprüche, **dadurch gekennzeichnet, dass** die Halterungseinrichtung (30) ohne die Sensoreinrichtung (40) als passives Bauteil ohne eigene elektrische Funktionalität ausgebildet ist.

5. Halterungseinrichtung nach einem der vorhergehenden Ansprüche, **dadurch gekennzeichnet, dass** wenigstens ein Fixierelement (33, 34) eines Befestigungsplatzes ein Rast-Fixierelement (35) aufweist, durch das eine Leiteranschlussklemme (1) durch Verrastung am Befestigungsplatz (31) befestigbar ist.

6. Halterungseinrichtung nach einem der vorhergehenden Ansprüche, **dadurch gekennzeichnet, dass** die Sensoreinrichtung (40) eine Drahtlos-Übertragungseinheit (43) aufweist, die zur drahtlosen Übertragung von Messwerten des wenigstens einen Sensors (41) der Sensoreinrichtung (40) an eine von der Sensoreinrichtung (40) separate Ausleseeinrichtung eingerichtet ist.

7. Halterungseinrichtung nach einem der vorhergehenden Ansprüche, **dadurch gekennzeichnet, dass** die Sensoreinrichtung (40) eine erste Drahtlos-Übertragungseinheit zur Übertragung von Messwerten eines von der Sensoreinrichtung (40) gemessenen Stroms und wenigstens eine zweite Drahtlos-Übertragungseinheit zur drahtlosen Übertragung von Messwerten einer von der Sensoreinrichtung (40) gemessenen Spannung oder Potentials aufweist.

8. Halterungseinrichtung nach einem der vorhergehenden Ansprüche, **dadurch gekennzeichnet, dass** die Sensoreinrichtung (40) zur drahtlosen Versorgung mit elektrischer Energie, die für den Betrieb der Sensoreinrichtung erforderlich ist, eingerichtet ist.

9. Halterungseinrichtung nach einem der vorhergehenden Ansprüche, **dadurch gekennzeichnet, dass** der wenigstens eine Sensor (41) ein Stromsensor ist, insbesondere ein kontaktloser Stromsensor.

10. Halterungseinrichtung nach einem der vorhergehenden Ansprüche, **dadurch gekennzeichnet, dass** der wenigstens eine Sensor (41) ein Spannungssensor ist oder ein weiterer Sensor (41) der Sensoreinrichtung (40) ein Spannungssensor ist.

11. Halterungseinrichtung nach einem der vorhergehenden Ansprüche, **dadurch gekennzeichnet, dass** die Sensoreinrichtung (40) zur Erfassung von wenigstens zwei oder wenigstens drei Spannungspotentialen von an Befestigungsplätzen (31) der Halterungseinrichtung (30) befestigten Leiteranschlussklemmen (1) eingerichtet ist.

12. Halterungseinrichtung nach einem der vorhergehenden Ansprüche, **dadurch gekennzeichnet, dass** die Sensoreinrichtung (40) zur Erfassung der Phasenlage eines von der Sensoreinrichtung erfassten Stroms gegenüber einem von der Sensoreinrichtung erfassten Spannungspotential eingerichtet ist.

13. Halterungseinrichtung nach einem der vorhergehenden Ansprüche, **dadurch gekennzeichnet, dass** die Halterungseinrichtung (30) ein Tragschienenbefestigungselement (37) aufweist, mit dem die Halterungseinrichtung (30) zumindest teilweise formschlüssig an einer Tragschiene der elektrischen Installationstechnik befestigbar ist.

14. Schaltschrank mit wenigstens einer Halterungseinrichtung (30) nach einem der vorhergehenden Ansprüche.

## Claims

1. Holding device (30) for fastening one or more conductor connection terminals (1) to an object, the holding device (30) having one or more fastening locations (31), at least one fixing element (33, 34) being arranged at a respective fastening location (31) for mechanically fixing one or more conductor connection terminals (1) to this fastening location (31) the holding device (30) having at least one sensor device (40) which has at least one sensor (41) for detecting a physical variable of at least one conductor connection terminal (1) fastened to a fastening location (31), **characterized in that** the sensor device (40) is structurally integrated into a housing (32) of the holding device (30).

2. Holding device according to one of the preceding claims, **characterized in that** the at least one sensor (41) is arranged at a position of the holding device (30) in the immediate vicinity of which a busbar (11) of a conductor connection terminal (1) fastened to a fastening location (31) is arranged.

3. Holding device according to one of the preceding claims, **characterized in that** one, several or all fastening locations (31) of the holding device (30) are set up for fastening a conductor connection terminal (1) using spring-loaded clamping technology.

4. Holding device according to one of the preceding claims, **characterized in that** the holding device (30) without the sensor device (40) is designed as a passive component without own electrical functionality.

5. Holding device according to one of the preceding claims, **characterized in that** at least one fixing element (33, 34) of a fastening location has a latching fixing element (35), by means of which a conductor connection terminal (1) can be fastened to the fastening location (31) by latching.

6. Holding device according to one of the preceding claims, **characterized in that** the sensor device (40) has a wireless transmission unit (43) which is set up for the wireless transmission of measured values of the at least one sensor (41) of the sensor device (40) to a readout device separate from the sensor device (40).

7. Holding device according to one of the preceding claims, **characterized in that** the sensor device (40) has a first wireless transmission unit for transmitting measured values of a current measured by the sensor device (40) and at least one second wireless transmission unit for wirelessly transmitting measured values of a voltage or potential measured by the sensor device (40).

8. Holding device according to one of the preceding claims, **characterized in that** the sensor device (40) is set up for the wireless supply of electrical energy required for the operation of the sensor device.

9. Holding device according to one of the preceding claims, **characterized in that** the at least one sensor (41) is a current sensor, in particular a contactless current sensor.

10. Holding device according to one of the preceding claims, **characterized in that** the at least one sensor (41) is a voltage sensor or a further sensor (41) of the sensor device (40) is a voltage sensor.

11. Holding device according to one of the preceding claims, **characterized in that** the sensor device (40) is set up to detect at least two or at least three voltage potentials of conductor connection terminals (1) fastened to fastening locations (31) of the holding device (30).

12. Holding device according to one of the preceding claims, **characterized in that** the sensor device (40) is set up to detect the phase position of a current detected by the sensor device relative to a voltage potential detected by the sensor device.

13. Mounting device according to one of the preceding claims, **characterized in that** the mounting device (30) has a mounting rail fastening element (37), with which the mounting device (30) can be fastened at least partially positively to a mounting rail of the electrical installation technology.

14. Switch cabinet with at least one holding device (30) according to one of the preceding claims.

## Revendications

1. Dispositif de maintien (30) destiné à fixer une ou plusieurs bornes de raccordement de conducteur (1) à un objet, le dispositif de maintien (30) présentant un ou plusieurs emplacements de fixation (31),
dans lequel au moins un élément de fixation (33, 34) destiné à fixer mécaniquement une ou plusieurs bornes de raccordement de conducteur (1) à un emplacement de fixation (31) respectif est disposé à cet emplacement de fixation (31),
le dispositif de maintien (30) comprend au moins un dispositif de détection (40) qui comprend au moins un capteur (41) destiné à détecter une grandeur physique d'au moins une borne de raccordement de conducteur (1) fixée à un emplacement de fixation (31),
**caractérisé en ce que** le dispositif de détection (40) est intégré structurellement dans un boîtier (32) du dispositif de maintien (30).

2. Dispositif de maintien selon la revendication précédente,
**caractérisé en ce que** ledit au moins un capteur (41) est disposé à une position du dispositif de maintien (30) à proximité immédiate de laquelle est disposé un rail conducteur (11) d'une borne de raccordement de conducteur (1) fixée à un emplacement de fixation (31).

3. Dispositif de maintien selon l'une des revendications précédentes,
**caractérisé en ce qu'**un, plusieurs ou tous les emplacements de fixation (31) du dispositif de maintien (30) destiné à la fixation d'une borne de raccordement de conducteur (1) sont conçus selon la technique de serrage par ressort.

4. Dispositif de maintien selon l'une des revendications précédentes,
**caractérisé en ce que** le dispositif de maintien (30), dépourvu du dispositif de détection (40), est conçu comme un composant passif sans fonctionnalité électrique propre.

5. Dispositif de maintien selon l'une des revendications précédentes,
**caractérisé en ce qu'**au moins un élément de fixation (33, 34) d'un emplacement de fixation présente un élément de fixation par encliquetage (35) permettant de fixer une borne de raccordement de conducteur (1) par encliquetage à l'emplacement de fixation (31).

6. Dispositif de maintien selon l'une des revendications précédentes,
**caractérisé en ce que** le dispositif de détection (40) comprend une unité de transmission sans fil (43) qui est conçue pour transmettre sans fil des valeurs de mesure dudit au moins un capteur (41) du dispositif de détection (40) à un dispositif de lecture distinct du dispositif de détection (40).

7. Dispositif de maintien selon l'une des revendications précédentes,
**caractérisé en ce que** le dispositif de détection (40) comprend une première unité de transmission sans fil, destinée à transmettre des valeurs de mesure d'un courant mesuré par le dispositif de détection (40), et au moins une deuxième unité de transmission sans fil, destinée à transmettre sans fil des valeurs de mesure d'une tension ou d'un potentiel mesuré(e) par le dispositif de détection (40).

8. Dispositif de maintien selon l'une des revendications précédentes,
**caractérisé en ce que** le dispositif de détection (40) est conçu pour l'alimentation sans fil en énergie électrique nécessaire au fonctionnement du dispositif de détection.

9. Dispositif de maintien selon l'une des revendications précédentes,
**caractérisé en ce que** ledit au moins un capteur (41) est un capteur de courant, en particulier un capteur de courant sans contact.

10. Dispositif de maintien selon l'une des revendications précédentes,
**caractérisé en ce que** ledit au moins un capteur (41) est un capteur de tension, ou un autre capteur (41) du dispositif de détection (40) est un capteur de tension.

11. Dispositif de maintien selon l'une des revendications précédentes,
**caractérisé en ce que** le dispositif de détection (40) est conçu pour détecter au moins deux ou au moins trois potentiels de tension de bornes de raccordement de conducteurs (1) fixées à des emplacements de fixation (31) du dispositif de maintien (30).

12. Dispositif de maintien selon l'une des revendications précédentes,
**caractérisé en ce que** le dispositif de détection (40) est conçu pour détecter la position de phase d'un courant, détecté par le dispositif de détection, par rapport à un potentiel de tension détecté par le dispositif de détection.

13. Dispositif de maintien selon l'une des revendications précédentes,
**caractérisé en ce que** le dispositif de maintien (30) comprend un élément de fixation sur rail porteur (37) permettant de fixer le dispositif de maintien (30) au moins partiellement par complémentarité de forme sur un rail porteur de la technique d'installation électrique.

14. Armoire électrique comprenant au moins un dispositif de maintien (30) selon l'une des revendications précédentes.
